# EUROPÄISCHE PATENTANMELDUNG

(11) **EP 1 078 776 A1**
(43) Veröffentlichungstag der Anmeldung: **28.02.2001**
(21) Anmeldenummer: 00117333.5
(22) Anmeldetag: 21.08.2000
(51) Int. Cl.: B41M 7/00, B41M 5/00, B44C 1/17, H05K 3/20

(54) **Selbstklebender Verbund**

(30) Priorität: 27.08.1999 DE 19940847
(71) Anmelder: Klaus König KG, 91052 Erlangen (DE)
(72) Erfinder: Schütz, Oswald, 91359 Leutenbach (DE)
(74) Vertreter: Ricker, Mathias, Dr.Dipl.-Chem.

(57) **Zusammenfassung**

Die vorliegende Erfindung betrifft einen selbstklebenden Verbund zum haftenden Aufbringen auf eine Oberfläche, wobei dieser selbstklebende Verbund eine Klebeschicht (A) und eine nicht-starre, zur Aufnahme von Farbe geeignete Funktionsschicht (B) aufweist. Sie betrifft weiterhin ein Verfahren zur Herstellung des selbstklebenden Verbunds sowie verschiedene Verwendungen, unter anderem als Körperschmuck, insbesondere als Tätowierungsimitat ( 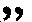 Tattoo"), sowie zur Herstellung von Einzel- und Musterstücken, etwa von Musterleiterplatten im Bereich der Halbleitertechnik.

## Beschreibung

Die vorliegende Erfindung betrifft einen selbstklebenden Verbund zum haftenden Aufbringen auf eine Oberfläche, wobei dieser selbstklebende Verbund eine Klebeschicht (A) und eine zur Aufnahme von Farbe geeignete Funktionsschicht (B) aufweist. Des weiteren betrifft die vorliegende Erfindung ein Verfahren zur Herstellung des selbstklebenden Verbunds sowie verschiedene Verwendungen, unter anderem als Körperschmuck, insbesondere als Tätowierungsimitat ( 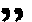 Tattoo"), sowie zur Herstellung von Einzel- und Musterstücken, etwa von Musterleiterplatten im Bereich der Halbleitertechnik.

Beispiele für selbstklebende Verbunde sind Papier- oder Folienbänder, Haftetiketten oder selbstklebende Dekorfolien. Neben diesen herkömmlichen Anwendungsgebieten für selbstklebende Verbunde wurden in den letzten beiden Jahrzehnten selbstklebende Verbunde auch als Körperdekoration, beispielsweise in Form von Tätowierungsimitaten, sog. 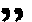 Tattoos", eingesetzt.

Tätowierungen sind eine altbekannte und weitverbreitete Art von Körperschmuck. Sie entstanden wahrscheinlich aus einem Verfahren, bei welchem Narben derart gesetzt wurden, daß sich Muster oder Bilder ergaben. In diesem Zusammenhang wurde vermutlich festgestellt, daß das Narbengewebe verfärbt wurde, wenn schmutzige oder farbige Instrumente verwendet wurden. Später wurden Methoden entwickelt, mittels derer Farbstoffe in gezielter Weise unter die Haut gebracht wurden. Moderne Tätowierungsverfahren umfassen die Verwendung von Nadeln von medizinischer Qualität, mittels derer beständige Farben und Pigmente in einer Weise subkutan injiziert werden, daß sichtbare Muster und Bilder entstehen. Diese herkömmliche Form der Tätowierung ist sowohl schmerzhaft als auch vergleichsweise kostspielig; hinzu kommt, daß die so hergestellte Tätowierung permanent ist, d.h. nicht ohne weiteres entfernt werden kann.

Aus diesem Grunde wurden verschiedene Typen von Tätowierungsimitaten entwickelt, d.h. Nachbildungen, die möglichst wie herkömmliche Tätowierungen aussehen, aber nicht deren genannte Nachteile aufweisen sollen. Im wesentlichen sind hierbei drei Klassen von Tätowierungsimitaten zu nennen, nämlich aufgemalte, transferierbare, sowie aufklebbare Tätowierungsimitate. Auch im deutschen Sprachraum hat sich für solche Tätowierungsimitate der Begriff 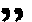 Tattoos" durchgesetzt. Im Rahmen der vorliegenden Erfindung wird dieser Begriff als Synonym für selbstklebende Tätowierungsimitate verwendet.

Benutzer von Tätowierungsimitate wünschen naturgemäß, daß derartige Imitate eine möglichst hohe Ähnlichkeit mit konventionellen, d.h. subkutanen Tätowierungen aufweisen. Dieser Anspruch läßt sich am ehesten durch aufgemalte Tätowierungsimitate erfüllen, ihre Herstellung erfordert jedoch vergleichsweise viel Zeit und Geschick. Auch transferierbare Tätowierungsimitate können relativ 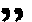 echt" aussehen. Dabei werden meist wasserlösliche, auf einem Träger in Form eines Musters oder eines Bildes aufgebrachte Farbstoffe dadurch auf die Haut transferiert, daß das Muster oder Bild angefeuchtet und gegen die Haut gedrückt wird. Dadurch entstehen häufig streifige, verschmierte oder nur partielle Abbildungen. Hinzu kommt, daß die wasserlöslichen Farbstoffe auf der Haut leicht verlaufen.

In diesem Zusammenhang offenbart die US 5,928,797 eine Vorrichtung sowie eine Methode zur Applikation nicht-permanenter Tätowierungsimitate, die eine beschränkte individuelle Gestaltung eines solchen temporären Tätowierungsimitats durch den Verbraucher erlaubt. Die hierin offenbarte Vorrichtung stellt eine mit Farbstoff gefüllte, für diesen Farbstoff undurchlässige Tasche dar, welche eine abnehmbare untere Schicht aufweist. Wird diese Schicht abgenommen, so kommt ein Muster zum Vorschein, welches dadurch gebildet wird, daß sich farbstoffpermeable und -impermeable Bereiche abwechseln. Wenn die Haut des Verbrauchers einem entsprechenden Farbstoff ausgesetzt und mit der beschriebenen Vorrichtung in Kontakt gebracht wird, so bildet sich ein Muster, welches dem 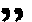 Stempelmuster" der beschriebenen Vorrichtung entspricht. Der Verbraucher hat dadurch, daß er farbstoffimpermeable Bereiche der genannten Vorrichtung ausschneiden und entfernen kann, gewisse Möglichkeiten zur individuellen Gestaltung eines Tätowierungsimitats.

Eine Möglichkeit zur vollkommen individuellen Gestaltung eines Tattoos durch den Verbraucher ist in der US 5,928,797 nicht offenbart; darüber hinaus ist die Methode, mittels derer diese beschränkten Gestaltungsmöglichkeiten erreicht werden können, sehr umständlich.

Die US 4,594,276 offenbart ein selbstklebendes Tätowierungsimitat ( 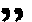 Tattoo"), welches im wesentlichen aus einer durchsichtigen, porösen, nicht-gewebten kompaktierten organischen polymeren filamentösen, d.h. faserigen Substratschicht, nämlich einem Film oder einem Netz, besteht, welche auf der einen Seite eine druckempfindliche Klebeschicht und auf der anderen dieser Substratschicht ein wasserbeständiges Bild aufWeist. In diesem US-Patent werden als Fasermaterialien beispielhaft Polyester, Polyvinylharze, Celluloseacetat, Celluloseacetatbutyrat, Celluloseacetatproprionat, Polyolefine, Rayon und Polyamid genannt, insbesondere werden medizinische Klebebänder als geeignet offenbart.

Ein entscheidender Vorteil einer derartigen faserhaltigen Substratschicht wird in der US 4,594,276 darin gesehen, daß sie keinen perfekten Aufdruck erlaubt und daher wie eine 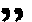 echte", herkömmliche Tätowierung aussieht. Es wird in diesem Zusammenhang offenbart, daß die Unebenheiten der Substratschicht und die daraus resultierende unregelmäßige Bedruckung Ähnlichkeiten mit dem Effekt bedingen, der bei 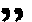 echten", d.h. subkutanen Tätowierungen im Laufe der Zeit durch die Migration der Farbe hervorgerufen wird. Es erscheint jedoch fraglich, ob dieser angebliche 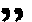 Vorteil" tatsächlich als ein solcher zu werten ist.

Den beschriebenen Tätowierungsimitaten ( 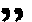 Tattoos") haftet beispielsweise der Nachteil an, daß diese insbesondere nach längerem Tragen Falten werfen und dadurch für den Betrachter als Imitate erkennbar sind.

Demgemäß besteht eine Aufgabe der vorliegenden Erfindung darin, einen selbstklebenden Verbund zur Verfügung zu stellen, welcher beispielsweise zur Herstellung von selbstklebenden Tätowierungsimitaten ( 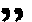 Tattoos") geeignet ist, aber nicht die Nachteile der herkömmlichen selbstklebenden Verbunde des Stands der Techniks aufweist. Eine spezifische Aufgabe der vorliegenden Erfindung besteht insbesondere darin, einen selbstklebenden Verbund zur Verfügung zu stellen, welcher eine gleichmäßige Bedruckung, Bemalung oder anderweitige Gestaltung erlaubt.

Eine weitere Aufgabe der vorliegenden Erfindung besteht darin, einen selbstklebenden Verbund zur Verfügung zur stellen, welcher beispielsweise zur Herstellung von selbstklebenden Tätowierungsimitaten ( 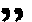 Tattoos") geeignet ist und dabei eine individuelle und gleichzeitig einfach zu handhabende Gestaltung der Motive durch den Verbraucher erlaubt.

Noch eine weitere Aufgabe der vorliegenden Erfindung besteht darin einen selbstklebenden Verbund bereitzustellen, der nicht nur auf der Haut, sondern auch auf einer Vielzahl üblicher Werkstoffe und Materialien haftet und der sich mittels verschiedener Druckverfahren bedrucken läßt.

Diese Aufgaben werden gelöst durch einen selbstklebenden Verbund, der eine Klebeschicht (A) und eine nicht-starre, zur Aufnahme von Farbe geeignete Funktionsschicht (B) aufweist.

Die vorliegende Erfindung umfaßt auch eine Ausführungsform, bei welcher der selbstklebende Verbund aus den zwei vorstehend genannten Schichten besteht.

Vor dem Aufbringen des erfindungsgemäßen Verbunds auf die gewünschte Oberfläche wird die Klebeschicht (A) in der Regel durch eine Abziehschicht (Z) abgedeckt sein, um sie vor Verschmutzung und Klebeverlust zu schützen.

Der erfindungsgemäße selbstklebende Verbund weist eine nicht-starre Funktionsschicht auf. Selbstklebende Verbunde des Standes der Technik weisen eine Funktionsschicht auf, die im Regelfall einen Faserverbund, beispielsweise Papier oder Textilien oder eine Folie, beispielsweise aus Kunststoffen, als Träger aufweisen, wodurch eine Starrheit der herkömmlichen selbstklebenden Verbunde bedingt wird. Im Unterschied hierzu ist im Rahmen der vorliegenden Erfindung eine nicht-starre, insbesondere eine trägerlose Funktionsschicht vorgesehen.

Im Rahmen der vorliegenden Erfindung wird demgemäß eine Ausführungsform bevorzugt, bei welcher der Verbund, insbesondere die Funktionsschicht (B), trägerlos ist, und insbesondere keinen Faserverbund und/oder Folie aufweist.

Der erfindungsgemäße selbstklebende Verbund weist in einer bevorzugten Ausführungsform eine hohe Elastizität auf. Wird er auf die Haut aufgebracht, so paßt er sich ihren Bewegungen weitgehend an, wodurch eine Faltungbildung weitestgehend oder sogar vollständig vermieden wird. In einer besonders bevorzugten Ausführungsform bildet der erfindungsgemäße selbstklebende Verbund einen matten oder matt-transparenten elastischen Film.

Es wurde gefunden, daß selbstklebende Verbunde gemäß der vorliegenden Erfindung eine Bedruckung insbesondere mittels Tintenstrahldruckverfahren erlauben. In einer weiteren Ausführungsform ist der erfindungsgemäße selbstklebende Verbund auch anderen Formen der Bedruckung, sowie allgemein jeglicher Art der Bemalung oder anderweitigen Gestaltung zugänglich.

Die Vorteile des erfindungsgemäßen selbstklebenden Verbunds sind darin zu sehen, daß unabhängig von dem im einzelnen gewählten Bedruckungsverfahren (beispielsweise Tintenstrahldruck, Laser-Jet-Druck, Siebdruck oder Offsetdruck) eine gleichmäßige Farbaufnahme möglich ist, wobei diese Qualität insbesondere durch Tintenstrahldruckverfahren erzielt wird. Somit werden dem Verbraucher individuelle Gestaltungsmöglichkeiten für die erfindungsgemäßen selbstklebenden Verbunde zur Verfügung gestellt, wodurch sich entsprechend vielfältige Anwendungsmöglichkeiten eröffnen.

Wie bereits erwähnt, bilden die erfindungsgemäßen Verbunde in einer bevorzugten Ausführungsform einen matten oder matt-transparenten, elastischen Film, der nahezu unsichtbar ist, wenn er auf die Haut oder auch auf Materialien wie beispielsweise Kunststoffen, Metall, Keramik oder Papier aufgebracht wird. Insbesondere im Falle der Haut bieten die erfindungsgemäßen selbstklebenden Verbunde in einer bevorzugten Ausführungsform den Vorteil, daß sie sich aufgrund ihrer Elastizität den Bewegungen der Haut anpassen, so daß nahezu keine oder überhaupt keine Faltenbildung auftritt. Die erfindungsgemäßen selbstklebenden Verbunde zeichnen sich also unter anderem dadurch aus, daß sie insbesondere auf flexiblen Oberflächen, beispielsweise der Haut, sehr gute Hafteigenschaften zeigen.

Bei dem erfindungsgemäßen selbstklebenden Verbund kann die Klebeschicht (A) prinzipiell auf allen dem Fachmann wohlbekannten üblichen Klebesubstanzen basieren, die auch im Zusammenhang mit herkömmlichen selbstklebenden Verbunden verwendet werden können, beispielsweise auf natürlichen Polymeren pflanzlichen oder tierischen Ursprungs, wie etwa Kautschuk und/oder auf gebräuchlichen, dem Fachmann als Klebesubstanzen bekannten Polykondensaten, Polymerisaten sowie Polyadditionsprodukten. Diese Klebesubstanzen können in Verbindung mit klebkrafterhöhenden Substanzen wie zum Beispiel Naturharzen und/oder Kohlenwasserstoffharzen eingesetzt werden.

Bevorzugt werden Haftklebstoffe eingesetzt, d.h. dauerklebrige Stoffe, die an den meisten Werkstoffoberflächen, etwa auf Metall, Kunststoffen, Keramik oder Papier, sowie auf der Haut und auf Finger- und Fußnägeln schon unter leichtem Andruck spontan haften. Beispielhaft seien Natur- und Synthesekautschuke sowie Polyacrylate und Polyvinylverbindungen genannt. Wie bereits erwähnt, können solche Haftklebstoffe in Verbindung mit klebkrafterhöhenden Substanzen wie etwa modifizierten Naturharzen und/oder synthetischen Harzen eingesetzt werden. Besonders bevorzugt sind hautverträgliche Klebesubstanzen wie beispielsweise Kautschuk, Acrylate oder Polyvinylacetate.

Im Rahmen der vorliegenden Erfindung können der Klebeschicht (A) prinzipiell alle dem Fachmann bekannten Additive zugesetzt werden.

In einer bevorzugten Ausführungsform enthält die Klebeschicht (A) basierend auf 100 Gewichtsteilen eines oder mehrerer wasserbasierender, selbstklebender Acrylsäureester etwa 10-40 Gewichtsteile eines oder mehrerer wasserbasierender Acrylestercopolymeren und geringe Mengen üblicher Additive.

Besonders bevorzugt enthält die Klebeschicht (A) basierend auf 100 Gewichtsteilen eines oder mehrerer wasserbasierender, selbstklebender Acrylsäureester etwa 25 - 35 Gewichtsteile eines oder mehrerer wasserbasierender Acrylestercopolymeren und geringe Mengen üblicher Additive.

Erfindungsgemäß weist die Klebeschicht (A) eine Dicke von 5-200 µm, bevorzugt von etwa 10-50 µm und besonders bevorzugt von etwa 20-30 µm auf.

Die zur Aufnahme von Farbe geeignete Funktionsschicht (B) kann auf jedem Stoff basieren, der, gegebenenfalls in Verbindung mit dem Fachmann bekannten Füll- und/oder Hilfsstoffen, eine flexible Beschaffenheit sowie eine Bedruckbarkeit, insbesondere mittels Tintenstrahldruckverfahren, Bemalbarkeit oder die Möglichkeit einer anderweitigen Gestaltung gewährleistet. Beispielhaft hierfür seien Acrylate, Polyvinylalkohole, Polyvinylacetat sowie Polyurethane genannt. Die Funktionsschicht (B) kann weiterhin dem Fachmann bekannte Additive, etwa Füllstoffe, Pigmente und/oder sonstige Hilfsstoffe enthalten.

In einer bevorzugten Ausführungsform enthält die Funktionsschicht (B) basierend auf 100 Gewichtsteilen eines oder mehrerer wasserbasierender, Polyvinylalkohole 10-40 Gewichtsteile einer oder mehrerer wasserbasierender Polyurethandispersionen und 5-25 Gewichtsteile einer oder mehrerer wasserbasierender quaternärer Ammoniumverbindungen und geringe Mengen üblicher Additive.

Besonders bevorzugt enthält die Funktionsschicht (B) basierend auf 100 Gewichtsteilen eines oder mehrerer wasserbasierender Polyvinylalkohole 20-30 Gewichtsteile einer oder mehrerer wasserbasierender Polyurethandispersionen und 10-20 Gewichtsteile einer oder mehrerer wasserbasierender quaternärer Ammoniumverbindungen und geringe Mengen üblicher Additive.

Erfindungsgemäß weist die Funktionsschicht (B) eine Dicke von 5 - 200 µm, bevorzugt von etwa 10-50 µm und besonders bevorzugt von etwa 25-35 µm auf.

Vorzugsweise ist die Funktionsschicht (B) des erfindungsgemäßen selbstklebenden Verbunds bedruckt oder in anderer Weise mit Farbe versehen oder anderweitig gestaltet. In diesem Zusammenhang wird auch auf die noch folgenden Ausführungen zur Herstellung des erfindungsgemäßen selbstklebenden Verbundes verwiesen.

Während der Herstellung und Lagerung weist der erfindungsgemäße selbstklebende Verbund in der Regel eine Abziehschicht (Z) auf, welche die Klebeschicht auf der der Funktionsschicht abgewandten Fläche bedeckt. Auf diese Weise wird beispielsweise eine platzsparende Lagerung, etwa durch Stapeln oder Rollen, ermöglicht. Des weiteren wird die Klebeschicht (A) auf diese Weise vor Haftverlust und Verschmutzung geschützt. Als Abziehschicht läßt sich jedes dem Fachmann bekannte Material verwenden, welches in der Lage ist im Zusammenhang mit herkömmlichen selbstklebenden Verbunden eine entsprechende Funktion zu erfüllen. Der Fachmann ist daher bei der Auswahl unter ihm geeignet erscheinenden Materialien keinerlei Einschränkungen unterworfen. Bevorzugt wird als Abziehschicht (Z) ein Material verwendet, an welches der erfindungsgemäße selbstklebende Verbund während der Verarbeitung ausreichend haftet, insbesondere beispielsweise während des Zuschneidens der Bögen sowie während des Bedruckens, etwa mittels eines Tintenstrahldruckers. Darüber hinaus sollte die Abziehschicht (Z) bevorzugt so gewählt sein, daß der erfindungsgemäße selbstklebende Verbund sich ohne größere Schwierigkeiten von der Abziebschicht (Z) abziehen läßt, gegebenenfalls mittels einer Übertragungsfolie, vorzugsweise mittels einer selbstklebenden Übertragungsfolie. Besonders bevorzugt wird als Abziehschicht (Z) handelsübliches silikonbeschichtetes Papier verwendet.

Im Rahmen der vorliegenden Erfindung wird auch ein Verfahren zur Herstellung eines vorstehend beschriebenen selbstklebenden Verbunds bereitgestellt, bei welchem mindestens eine Klebeschicht (A) und mindestens eine zur Aufnahme von Farbe geeignete Funktionsschicht (B) haftend miteinander verbunden werden.

Die Herstellung des erfindungsgemäßen selbstklebenden Verbundes erfolgt in der Regel dadurch, daß die beiden Schichten auf eine Hilfsschicht, beispielsweise die Abziebschicht (Z), aufgebracht werden. Hierbei wird zumeist zunächst die Klebeschicht (A) auf die Hilfsschicht, beispielsweise auf die Abziehschicht (Z), aufgebracht, und nachfolgend die Funktionsschicht (B) auf die Klebeschicht (A). Hierbei werden die beiden Schichten (A) und (B) haftend miteinander verbunden.

Die Schichten werden in Form von Flüssigkeiten oder Massen, vorzugsweise in Form von Flüssigkeiten, aufgebracht. Entsprechende Verfahren sind dem Fachmann wohlbekannt, beispielhaft seien hier Spritzen, Walzen und Rakeln genannt. Nach dem Trocknen wird die Hilfsschicht, beispielsweise die Abziehschicht (Z), auf die der erfindungsgemäße selbstklebende Verbund aufgebracht ist, in Bögen geschnitten, vorzugsweise in Bögen mit leicht bedruckbaren Formaten, oder andersweitig gelagert, etwa in Form von Rollen.

Es wurde bereits angedeutet, daß selbstklebende Verbunde gemäß der vorliegenden Erfindung für eine Vielzahl verschiedener Verwendungen geeignet sind, einschließlich einer Verwendung als Körperschmuck. Entsprechend läßt sich der erfindungsgemäße selbstklebende Verbund als selbstklebendes Tätowierungsimitat ( 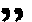 Tattoo") auf der Haut sowie zur Dekoration von Finger- und Fußnägeln verwenden. Aufgrund der Bedruckbarkeit, Bemalbarkeit oder sonstigen Gestaltbarkeit des erfindungsgemäßen selbstklebenden Verbundes nicht zuletzt auch mit dem Verbraucher zugänglichen Mitteln, beispielsweise mittels Tintenstrahldruckverfahren, ist die Möglichkeit zur individuellen, aber dennoch unkomplizierten Gestaltung eines solchen Körperschmucks durch den einzelnen Benutzer gegeben.

Zu diesem Zweck wird das gewünschte Motiv zunächst auf den erfindungsgemäßen selbstklebenden Verbund gedruckt, beispielsweise mittels eines Tintenstrahldruckverfahrens, oder gemalt. Nach der Bedruckung oder Bemalung wird der erfindungsgemäße selbstklebende Verbund von der Abziehschicht (Z) abgezogen, gegebenenfalls mittels einer Übertragungsfolie, vorzugsweise einer selbstklebenden Übertragungsfolie, und auf die gewünschte Hautpartie oder auf einen Finger- oder Zehennagel aufgeklebt.

Darüber hinaus ist ein Einsatz des erfindungsgemäßen selbstklebenden Verbunds bei jeglicher Anwendung denkbar, die eine einfach zu handhabende, individuelle Ausgestaltung eines Gegenstands zum Ziel hat, etwa im Bereich des Modellbaus, bei der Herstellung von Einzel- und Mustergegenständen, etwa zu Vorführungszwecken.

Beispielhaft sei an dieser Stelle die Herstellung von Musterleiterplatten im Bereich der Halbleitertechnik genannt. Mit Hilfe solcher Musterleiterplatten läßt sich die mechanische Funktionalität von Leiterplatten bereits vor der Ätzung innerhalb kurzer Zeit überprüfen. Zu diesem Zweck wird das gewünschte Leitungsmuster zunächst auf den erfindungsgemäßen selbstklebenden Verbund gedruckt, beispielsweise mittels eines Tintenstrahldruckverfahrens. Nach der Bedruckung wird der erfindungsgemäße selbstklebende Verbund von der Abziehschicht (Z) abgezogen, gegebenenfalls mittels einer Übertragungsfolie, vorzugsweise einer selbstklebenden Übertragungsfolie, und auf ein entsprechendes Musterelement geklebt.

Demgemäß betrifft die vorliegende Erfindung auch die Verwendung des erfindungsgemäßen selbstklebenden Verbunds als Körperschmuck sowie zur Herstellung von Muster- und Einzelstücken, etwa zur Herstellung von Musterleiterplatten in der Halbleitertechnik.

Im folgenden wird die vorliegende Erfindung anhand der beiliegenden Zeichnung beispielhaft näher erläutert.

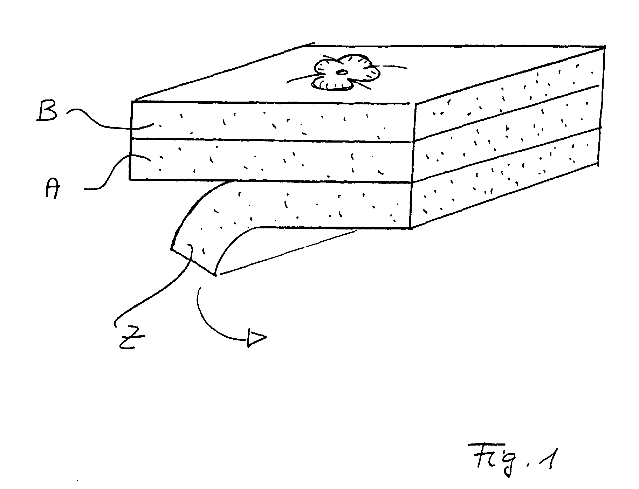

Figur 1: Zeigt eine Ausführungsform eines selbstiklebenden Verbundes gemäß der vorliegenden Erfindung.

Der selbstklebende Verbund weist eine Klebeschicht (A) auf, welche haftend mit einer zur Aufnahme von Farbe geeigneten Funktionsschicht (B) verbunden ist. Abgesehen von einer Abziehschicht (Z), die vor Gebrauch entfernt wird, weist der selbstklebende Verbund, insbesondere die Funktionsschicht (B), keine starren Elemente, insbesondere keine Träger wie etwa Faserverbunde oder Folien auf. Die Abziehschicht (Z) deckt die Klebeschicht (A) ab. Die Abziehschicht (Z) ist ein handelsübliches silikonbeschichtetes Papier. Wie dargestellt, kann auf der Funktionsschicht (B) ein beliebiges Motiv oder sonstige Dekoration, beispielsweise mittels eines Druckverfahrens, insbesondere mittels eines Tintenstrahldruckverfahrens, aufgebracht sein. Dieser selbstklebende Verbund kann als Tätowierungsimitat ( 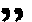 Tattoo") verwendet werden. Hierzu wird die Abziehschicht (Z) entfernt und der selbstklebende Verbund mittels der Klebeschicht (A) auf die Haut aufgeklebt. Der selbstklebende Verbund kann alternativ auch auf ein beliebiges anderes Material, etwa Metall, Kunststoffe, Keramik oder Papier aufgebracht werden, gegebenenfalls mittel einer Übertragungsfolie, vorzugsweise einer selbstklebenden Übertragungsfolie.

Die vorliegende Erfindung wird mittels des folgenden Herstellungsbeispieles näher erläutert.

### Herstellungsbeispiel:

Ein erfindungsgemäßes Verbundmaterial wurde wie folgt hergestellt:

### 1. Zusammensetzung der Funktionsschicht B

- 100 kg Polyvinylalkohol (wäßrig, 10 Gew.-% Feststoff, Viskosität 60 ± 5 mPas im Höppler-Viskosimeter, 20 °C)
- 16 kg quaternäre Ammoniumverbindung (30 - 35 Gew.-% Feststoff, Polymer auf Acrylatbasis, kationisch wirkend, CAS Nr. 79-41-4)
- 27 kg Polyurethandispersion (30 - 35 Gew.-% Feststoff)
- Füllstoffe, Pigmente und Additive

### 2. Zusammensetzung der Klebeschicht A

- 92 kg Acrylsäureester (30 - 35 Gew.-% Feststoff, wäßrig)
- 27 kg Acrylestercopolymer (55 - 65 Gew.-% Feststoff, wäßrig)
- Additive

Die jeweiligen Zusammensetzungen wurden gemischt. Es wurde auf ein Silikon beschichtetes Papier zunächst die Klebeschicht A durch Rakeln in einer Dicke von 20 bis 30 µm aufgetragen. Danach wurde die Funktionsschicht B ebenfalls durch Rakeln aufgetragen. Nach dem Trocknen wurde das Verbundmaterial in DinA-4-Bögen geschnitten.

Dieses Verbundmaterial läßt sich in einem Tintenstrahldrucker mit beliebigen Mustern bedrucken. Die selbstklebende Folie kann dann von der Abziehschicht abgezogen werden und beispielsweise als Tattoo auf die Haut geklebt werden.

## Patentansprüche

1. Selbstklebender Verbund aufweisend eine Klebeschicht (A) und eine nichtstarre, zur Aufnahme von Farbe geeignete Funktionsschicht (B).

2. Selbstklebender Verbund nach Anspruch 1 bestehend aus mindestens einer Klebeschicht (A) und mindestens einer nicht-starren, zur Aufnahme von Farbe geeigneten Funktionsschicht (B).

3. Selbstklebender Verbund nach Anspruch 1 oder 2, dadurch gekennzeichnet, daß der Verbund, insbesondere die Funktionsschicht (B), trägerlos ist, insbesondere keinen Faserverbund und/oder Folie aufweist.

4. Selbstklebender Verbund nach einem der vorstehenden Ansprüche, dadurch gekennzeichnet, daß die Klebeschicht (A) auf mindestens einer hautverträglichen Substanz, insbesondere einem oder mehreren Acrylsäureester, basiert.

5. Selbstklebender Verbund nach einem der vorstehenden Ansprüche, dadurch gekennzeichnet, daß die Funktionsschicht (B) auf mindestens einem Stoff ausgewählt aus der Gruppe bestehend aus Acrylat, Polyvinylalkohol, Polyvinylacetat und Polyurethan basiert.

6. Selbstklebender Verbund nach einem der vorstehenden Ansprüche, dadurch gekennzeichnet, daß die Funktionsschicht (B) Füllstoffe und Hilfsstoffe enthält.

7. Selbstklebender Verbund nach einem der vorstehenden Ansprüche, dadurch gekennzeichnet, daß die Klebeschicht (A) basierend auf 100 Gewichtsteilen eines oder mehrerer wasserbasierender, selbstklebender Acrylsäureester etwa 10-40 Gewichtsteile eines oder mehrerer wasserbasierender Acrylestercopolymeren und geringe Mengen üblicher Additive und die Funktionsschicht (B) basierend auf 100 Gewichtsteilen eines oder mehrerer wasserbasierender Polyvinylalkohole 10-40 Gewichtsteile einer oder mehrerer wasserbasierender Polyurethandispersionen und 5 -25 Gewichtsteile einer oder mehrerer wasserbasierender quaternärer Ammoniumverbindungen und geringe Mengen üblicher Additive enthält.

8. Selbstklebender Verbund nach einem der vorgehenden Ansprüche, dadurch gekennzeichnet, daß die Klebeschicht (A) durch eine Abziehschicht (Z) abgedeckt ist.

9. Selbstklebender Verbund nach einem der vorgehenden Ansprüche, dadurch gekennzeichnet, daß die Funktionsschicht (B) bedruckt oder in anderer Weise mit Farbe versehen oder anderweitig gestaltet ist.

10. Verfahren zur Herstellung eines selbstklebenden Verbunds gemäß einem der vorstehenden Ansprüche, wobei mindestens eine Klebeschicht (A) und mindestens eine nicht-starre, zur Aufnahme von Farbe geeignete Funktionsschicht (B) haftend miteinander verbunden werden.

11. Verwendung eines selbstklebenden Verbunds gemäß einem der Ansprüche 1-9 als Körperschmuck, insbesondere als Tätowierungsimitat ( 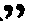 Tattoo").

12. Verwendung eines selbstklebenden Verbunds gemäß einem der Ansprüche 1-9 zur Herstellung von Muster- und Einzelstücken wie Musterleiterplatten oder Tätowierungsimitaten ( 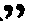 Tattoos") durch Bedrucken, insbesondere mittels eines Tintenstrahldruckers.
